# EUROPEAN PATENT SPECIFICATION

(11) **EP 2 748 639 B1**
(45) Date of publication and mention of the grant of the patent: **17.07.2019**
(21) Application number: 12819019.6
(22) Date of filing: 12.12.2012
(51) Int. Cl.: G01T 1/24

(54) **RADIATION DETECTOR**
STRAHLUNGSDETEKTOR
DÉTECTEUR DE RAYONNEMENT

(30) Priority: 13.12.2011 US 201161569833 P
(43) Date of publication of application: 02.07.2014
(73) Proprietor: Koninklijke Philips N.V., 5656 AE Eindhoven (NL); Philips GmbH, 22335 Hamburg (DE)
(72) Inventor: ENGEL, Klaus, Jürgen, NL-5656 AE Eindhoven (NL); HERRMANN, Christoph, NL-5656 AE Eindhoven (NL)
(74) Representative: Steffen, Thomas
(86) International application number: PCT/IB2012/057212
(87) International publication number: WO 2013/088352

(56) References cited:
- DE-A1-102007 055 676
- US-A1- 2005 249 331
- US-A1- 2007 280 409

## Description

### FIELD OF THE INVENTION

The present invention relates to a radiation detector and a radiation detection apparatus, in particular for detection of X-ray and gamma radiation.

### BACKGROUND OF THE INVENTION

Energy resolving detectors for X-ray and gamma radiation based on direct conversion materials, as for example CdTe or CZT, has been proven as an efficient way to measure photon energies. Direct conversion X-ray and gamma ray detectors typically comprise a layer of semiconducting material with metal electrodes on opposing surfaces between which a voltage is supplied. Incident X-ray photons produce a large number of electron-hole pairs almost proportional to the absorbed photon energy. Due to the electric field, the holes and electrons drift in opposite directions until they are collected by the metal electrodes. Usually a continuous metal electrode is used on the surface through which the photons are incident (typically used as cathode), and an array of pixel electrodes on the opposite surface (typically used as anode pixels). In this geometry, position and energy of an absorbed photon can be determined from the current pulse induced on the corresponding pixel anode as described in K.J. Engel and C. Herrmann, Simulation of one-dimensionally polarized X-ray semiconductor detectors, Proceedings of SPIE 7961, 79610W (2011).

The drift motion of electrons is overlaid by diffusion, which causes an extension of the electron cloud with time. If the cloud is located near the border between neighbouring pixels, it happens that a part of the cloud is collected by one pixel and another part of the cloud by the neighbouring pixel, a process which is well-known as "charge sharing". In result, in both pixels a count is triggered, each of them indicating a (more or less random) part of the original charge such that the original energy information gets lost.

DE 10 2007 055 676 A1 discloses a radiation converter for radiation detection of X-ray computer tomography. The converter has a solid state-conversion layer for direct conversion of a radiation e.g. corpuscular radiation, in electrical charge carriers, electrons and holes, and a set of discrete pixel electrodes attached on a side of the conversion layer. A counter electrode is attached on another side of the conversion layer, where the latter side is opposite to the former side and the conversion layer comprises deletion electrodes and contacts. One of the deletion electrodes is assigned to the counter electrode.

### SUMMARY OF THE INVENTION

It is an object of the present invention to provide a radiation detector and a radiation detection apparatus in which the above described charge sharing is reduced.

In a first aspect of the present invention a radiation detector is presented as defined in claim 1.

In a further aspect of the present invention a radiation detection apparatus is presented comprising:
- a radiation detector as proposed according to the first aspect, and
- a voltage source coupled to said cathode terminal for coupling different electrical potentials to said first and second cathode segments.

Preferred embodiments of the invention are defined in the dependent claims. It shall be understood that the claimed radiation detection apparatus has similar and/or identical preferred embodiments as the claimed radiation detector and as defined in the dependent claims.

The present invention is based on the idea to use a segmented cathode to reduce the problem of charge sharing. The cathode segments are held on different electric potentials such that a non-homogeneous electric field exists near the cathode directly above pixel border zones (i.e. above the anode gaps) such that generated electron clouds get an additional drift component towards a pixel centre (i.e. towards the centre of an anode segment). In result, the centre of gravity of each cloud is found closer to the corresponding pixel centre, and the charge sharing with the neighbouring pixel(s) is reduced.

It shall be noted that the terms "anode" and "cathode" and the functions of these elements may also be exchanged if a material is used for the semiconductor element where the signal generation with holes is more efficient than the signal generation with electrons. In other words, i.e. the same geometry is used but a different polarity of the electrodes (cathodes and anodes) is used. Hence, in case of using such a semiconductor element the claims directed to the radiation detector and the radiation detection apparatus shall be understood as covering a detector and an apparatus where anode and cathode are exchanged, i.e. the anode is facing the radiation and the cathode is arranged on the opposite side of the semiconductor element.

Accordingly, in a second aspect the present invention provides a radiation detector as defined in claim 11.

Further, in another aspect the present invention provides a radiation detection apparatus comprising:
- a radiation detector according to the second aspect, and
- a voltage source coupled to said anode terminal for coupling different electrical potentials to said first and second anode segments.

According to a preferred embodiment said first cathode segments are arranged as an array of first cathode segments. Preferably, the anode segments are arranged as an array as well, preferably of the same structure as the array of the first cathode segments. This embodiment provides a regular arrangement where single cathode and anode segments can be addresses in a simple manner.

According to another embodiment said first cathode segments have substantially the same form in directions parallel to the second surface than said anode segments.

There are different embodiments for implementing said cathode terminal. In one embodiment said cathode terminal comprises a first cathode terminal coupled to said first cathode segments and a second cathode terminal coupled to said second cathode segments for coupling different electrical potentials to said first and second cathode terminals.

In another embodiment the cathode terminal may be a layer to which the semiconductor is bounded by means of e.g. "bump balls" and which provides a routing of electrical connections.

In still another embodiment the cathode terminal provides electrical conductive contacts between two (or more) voltage sources and each cathode segment (or connected groups of cathode segments).

There are different embodiments for addressing the first cathode segments. In a first embodiment said first cathode segments are separated (in particular isolated) from each other and are individually coupled to a first cathode terminal. This embodiment provides the advantage that each cathode segment can be individually provided with an electrical potential, but requires a large number of cathode terminals. In an alternative embodiment said first cathode segments are coupled together in groups, in particular per row or per column, by cathode connection electrodes arranged on said second surface of said semiconductor element, said groups being individually coupled to a first cathode terminal. This embodiment requires a lower number of cathode terminals.

Preferably said second cathode segments are arranged as a grid of second cathode segments. In such an embodiment preferably a single second cathode terminal is sufficient that is coupled to the complete grip. Alternatively, said second cathode segments are coupled together in a single or multiple groups being coupled to one or multiple second cathode terminals enabling a more individual provision of electrical potentials to the second cathode segments.

In a further embodiment said cathode electrode is segmented into at least three cathode segments, wherein said first cathode segments are substantially arranged opposite said anode segments and the further cathode segments are nested around said first cathode segments, and wherein said cathode terminal provides electrical connections to different cathode segments for coupling different electrical potentials to said different cathode segments. Preferably, in an embodiment said cathode terminal comprises at least three cathode terminals being coupled to different cathode segments for coupling different electrical potentials to said different cathode terminals. These embodiments provide further improvements to avoid or suppress charge sharing.

Preferably, said semiconductor element is adapted for generating electron-hole pairs in response to an irradiation with X-ray or gamma radiation. For instance, said semiconductor element is made from an elemental semiconductor material, for example Si or Ge, a binary semiconductor material selected from the IV-group of the periodic system, in particular SiGe or SiC, a binary semiconductor material from the groups III and V of the periodic system, for example InP, GaAs or GaN, a binary semiconductor material from the groups II and VI of the periodic system, for example CdTe, HgTe, CdSe or ZnS, a binary semiconductor material from the groups IV and VI of the periodic system, for example PbO or PbS, a ternary semiconductor material, for example CdZnTe, HgCdTe, or AlGaAs, or a quaternary semiconductor material, for example InGaAsP or InGaAlP.

Advantageously, said radiation detector can further comprise anode gap segments arranged within said anode gaps between adjacent anode segments and an anode terminal providing electrical connections to said anode gap segments for coupling an electrical potential to said anode gap segments, in particular an electrical potential that is more negative (or, in other embodiments, more positive) than the electrical potential of said anode segments. This provides the ability of further steering the electrons towards a pixel anode segment, therefore reducing charge sharing by reducing the number of electrons which traverse the border to neighboring pixels. Furthermore, the capacitive coupling of charges (i.e. holes) within the bulk to the anode segments is reduced such that a more reliable signal is generated by the anode segments.

In general, for the implementation of the anode terminal the same holds that has been explained above for the cathode terminal, i.e. there are various embodiments possible. In one embodiment said anode terminal comprises a first anode terminal coupled to said anode segments and a second anode terminal coupled to said anode gap segments for coupling an electrical potential to said second anode terminals, which is preferably more negative compared to said first anode terminal.

In an embodiment of the radiation detection apparatus said voltage source is adapted for coupling an electrical potential to said second cathode segments that provides a larger voltage difference to said anode electrode than an electrical potential coupled to said first cathode segments. Further, said voltage source is preferably adapted for coupling electrical potentials to said first and second cathode segments having a voltage difference in the range between 10 V and 200 V and/or said voltage source is adapted for coupling electrical potentials to said first and second cathode segments having a voltage difference to the electrical potential of said anode electrode in a typical range between 50 V and 1000 V.

### BRIEF DESCRIPTION OF THE DRAWINGS

These and other aspects of the invention will be apparent from and elucidated with reference to the embodiment(s) described hereinafter. In the following drawings
Fig. 1 shows a cross sectional view of an embodiment of a radiation detection apparatus according to the present invention,
Fig. 2 shows a top view of a first embodiment of a radiation detector according to the present invention,
Fig. 3 shows a top view of a second embodiment of a radiation detector according to the present invention,
Fig. 4 shows a top view of a third embodiment of a radiation detector according to the present invention, and
Fig. 5 shows a cross sectional view of a fourth embodiment of a radiation detector according to the present invention.

### DETAILED DESCRIPTION OF THE INVENTION

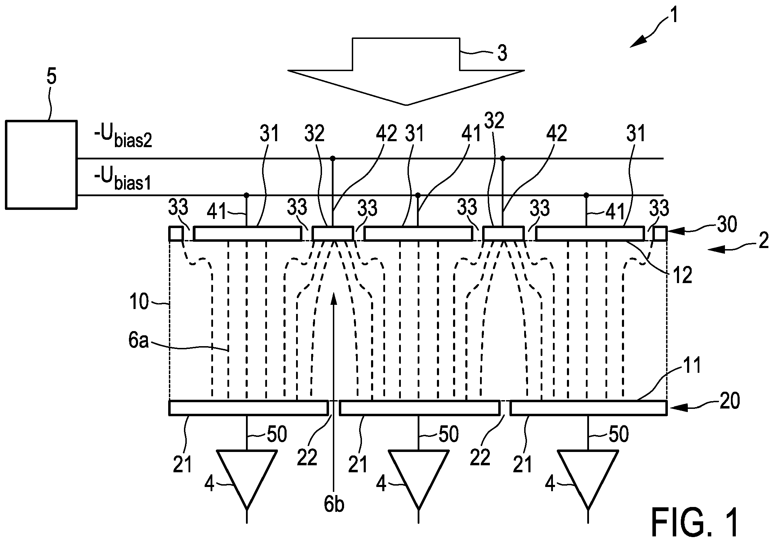

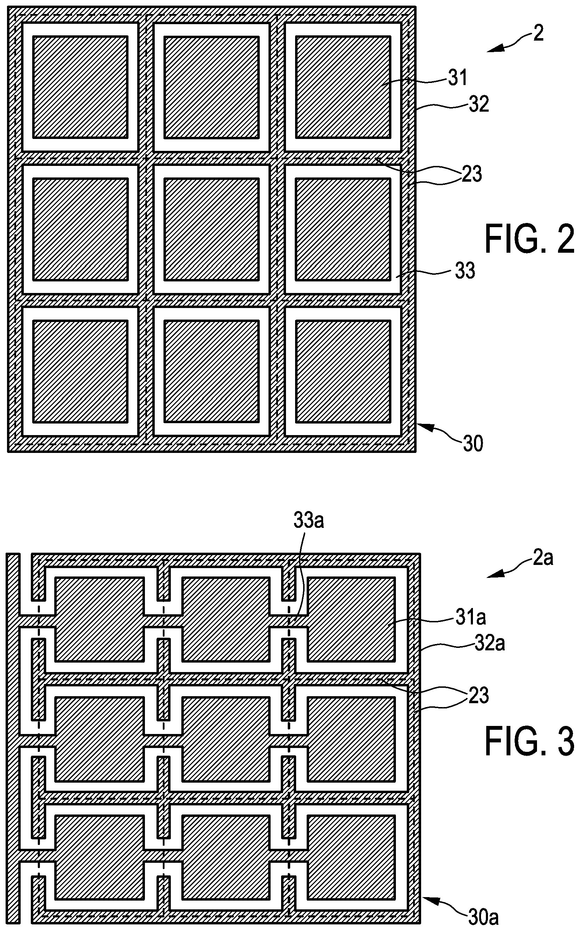

Fig. 1 shows a cross sectional view of an embodiment of a radiation detection apparatus 1 according to the present invention including a radiation detector 2, with a viewing direction perpendicular to the direction of radiation 3 (e.g. X-ray or gamma radiation), which is incident through the plane in which the cathode segments are arranged. Fig. 2 shows a first embodiment of a radiation detector 2 in a top view onto the cathode segments along the direction of incident radiation 3.

As shown in Figs. 1 and 2 the proposed radiation detector 2 comprises a radiation sensitive semiconductor element 10 generating electron-hole pairs in response to an irradiation with said radiation 3. Such a semiconductor element 10 is generally known in the art and may be made from an elemental semiconductor material, in particular Si or Ge, a binary semiconductor material selected from the IV-group of the periodic system, in particular SiGe or SiC, a binary semiconductor material from the groups III and V of the periodic system, for example InP, GaAs or GaN, a binary semiconductor material from the groups II and VI of the periodic system, for example CdTe, HgTe, CdSe or ZnS, a binary semiconductor material from the groups IV and VI of the periodic system, for example PbO or PbS, a ternary semiconductor material, for example CdZnTe, HgCdTe, or AlGaAs, or a quaternary semiconductor material, for example InGaAsP or InGaAlP. In other embodiments the semiconductor material may be selected which provides a more efficient signal generation by holes than by electrons in which case the same geometry of the radiation detector can be used but with a different polarity of the electrodes (cathodes, anodes, i.e. with cathodes and anodes exchanged).

The radiation detector 2 further comprises a (metal) anode electrode 20 arranged on a first surface 11 of the semiconductor element 10 facing away from the radiation 3. Said anode electrode 20 is segmented into anode segments 21 representing anode pixels, wherein electrode-free (i.e. non-metalized) anode gaps 22 are arranged between said anode segments 21.

On the opposite surface 12 of the semiconductor element 10 facing the radiation 3 the radiation detector 2 further comprises a (metal) cathode electrode 30. Said cathode electrode 30 is segmented into first cathode segments 31 and second cathode segments 32. Said first cathode segments 31 are substantially arranged opposite said anode segments 21 and said second cathode segments 32 are substantially arranged opposite said anode gaps 22. Between said first and second cathode segments 31, 32 non-metalized cathode gaps 33 are provided for isolation.

Still further cathode terminals 40 are provided comprising a first cathode terminal 41 coupled to said first cathode segments 31 and a second cathode terminal 42 coupled to said second cathode segments 32 for coupling different electrical potentials to said first and second cathode terminals 31, 32.

Preferably, anode terminals 50 are provided that are coupled to said anode segments 21 for coupling an electric potential, e.g. ground potential, to the anode segments 21 and/or for coupling signal electronics 4 (e.g. amplifiers, signal processors, storage elements, etc.) of the radiation detection apparatus 1 to the anode segments for signal readout and signal processing.

In this embodiment the square-like first cathode segments 31 correspond in lateral position to the anode segments 21, while the grating-like second cathode segments 32 correspond to the border zones (i.e. the anode gaps 22) between the anode segments 21. Preferably, according to an embodiment of the present invention, the second cathode segments 32 are put to a more negative electrical potential -U_{bias2} compared to that of the first cathode segments 31 which are put on a potential -U_{bias1}, which is preferably achieved by use of a voltage source 5 (or several separate voltage sources) coupled to said cathode terminals 41, 42 for coupling different electrical potentials to said first and second cathode terminals 41,42.

As shown in Fig. 1 within the largest volume related to a pixel (a pixel being defined by an anode segment 21; pixel borders being indicated in Fig. 1 by dashed lines 23), the electric field lines 6a represent a nearly homogeneous field. In the volume corresponding to pixel borders, the electric field lines 6b are bent especially near the second cathode segments 32 in a way that electrons (mainly following the path of field lines) are pushed towards pixel centres, i.e. the centres of the anode segments 21. This effectively results in a lateral shift of the electron cloud towards a pixel centre if it approaches the anode electrode 20, thus causing less overlap with the neighbouring pixels and therefore causing less charge sharing, which increases the probability that counts are registered with the correct original photon energy.

In the embodiment of the radiation detector 2 shown in Fig. 2 the pixel borders 23 are ideally covered with second cathode segments 32. The first cathode segments 31 need to be individually electrically contacted by first cathode terminals 41 in this embodiment, while generally a single second cathode terminal 42 for contacting said second cathode segments 32 that are all electrically connected is sufficient.

A second embodiment of a radiation detector 2a which may also be used in the radiation detection apparatus 1 is shown in a top view in Fig. 3, showing particularly the segmentation of the cathode electrode 30a. In this embodiment the pixel borders 23 are not ideally covered with second cathode segments 32a. The first cathode segments 31a are group-wise electrically connected in this embodiment (in the example shown in Fig. 3 along rows) by cathode connection electrodes 33a allowing for a single contact point (i.e. a single first cathode terminal 41) for each group of connected first cathode segments 31a for the bias-voltage supply. The second cathode segments 32a are still all connected but not as a continuous regular grid shown in Fig. 2 but with gaps.

It should be noted that the effect of charge sharing is the bigger the closer to the cathode side the radiation interaction happens, since in this case drift time of the generated electrons toward the pixel anode reaches its maximum so that the electron cloud has the largest amount of time to extend until reaching the pixel anode.

The geometrical sizes of the radiation detector 2, 2a are scalable. Typically, the thickness of a radiation detector 2, 2a is between 0.5 and 5 mm, the pixel sizes (anode segments 21) are between 50 and 2000 µm. Typical anode gaps 22 between anode segments 21 are sized between 20 and 500 µm.

U_{bias1} is typically chosen to generate an electric field between 30 and 500 V/mm. The anode segments 21 are typically on an electric potential of 0 V (or virtual GND).

A typical size of the second cathode segments 32 should correspond to the typical depth of X-ray interaction, i.e. about 50-500 µm, as the zone of bent electric field lines in depth corresponds to the "thickness" of the grating lines of the second cathode segments 32. Accordingly the voltage difference between U_{bias2} and U_{bias1} should be chosen as a best compromise between minimizing the emission current of second cathode segments 32 (which is partly collected by the anode pixels 21) and maximizing the electric field bending around the second cathode segments 32.

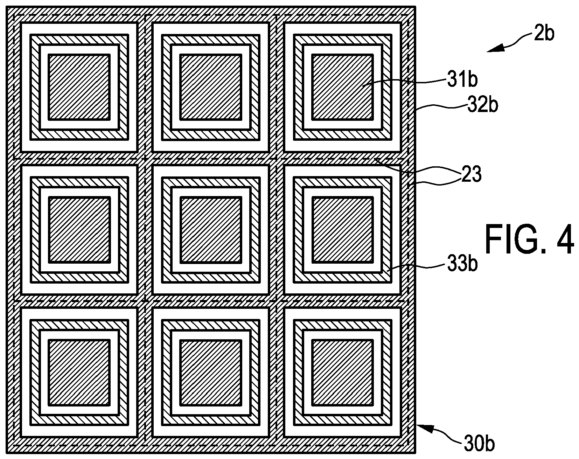

The electric field bending can be optimized by using more than two cathode segmentations, i.e. by using nested cathode segments 31b, 32b, 33b with increasing negative electric potential towards the border zone 23 between pixels as schematically illustrated in Fig. 4 showing a third embodiment of a radiation detector 2b according to the present invention. Fig. 4 particularly shows a segmentation of the cathode electrode 30b, where a second cathode segment 32b and a third cathode segment 33b is arranged around the central first cathode segment 31b.

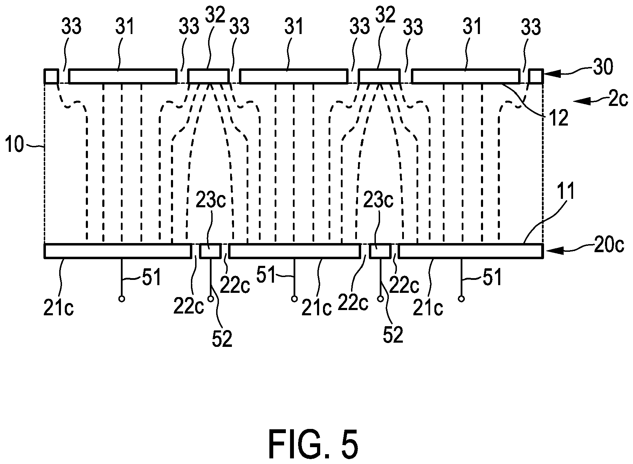

Optionally, the anode segmentation can be further improved, for example by using a well-known steering electrode technology (as e.g. disclosed in US 6,333,504). An embodiment of such a radiation detector 2c in a cross section is shown in Fig. 5. In this embodiment the anode electrode 20c comprises not only the anode segments 21c and the anode gaps 22c, but also anode gap segments 23c arranged within said anode gaps 22c between adjacent anode segments 21c. Further, first anode terminal 51 coupled to said anode segments 21c and a second anode terminal 52 coupled to said anode gap segments 23c are provided for coupling different electrical potentials to said first and second anode terminals 51, 52 such that the electric potential of the anode gap segments 23c is more negative than the electrical potential of the anode segments 21c. This provides the ability of further steering the electrons towards the center of a pixel anode segment which reduces charge sharing with neighboring pixels. Most advantageous is the cooperative steering effect of said second cathode segments 32 with said anode gap segments, where said cathode segments 32 ideally steer the whole electron cloud in an early stage towards the pixel centre, while the steering of the anode gap segments 23c avoid that larger (i.e. outer) parts of the electron cloud (which is expanding with time by diffusion) are collected by neighboring pixels. Furthermore, the capacitive coupling of charges within the bulk to the pixel anode segments is reduced such that a more reliable signal is generated by the pixel anode segments.

Further, generally holds that the more negative potential U_{bias2} may slightly increase the dark current. Thus U_{bias2} should be chosen such that the additional noise on the current signals is acceptable.

The invention is particularly applicable to all sorts of direct conversion detectors, in which electron-hole pairs are generated by photons. More specifically, these photons can be X-ray or gamma photons. One application of the invention is particularly for photon counting detectors in X-ray spectral imaging. Hence the proposed radiation detector apparatus may be included in various kinds of X-ray devices, CT devices or gamma radiation detection devices.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. The invention is only limited by the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A radiation detector comprising:
- a radiation sensitive semiconductor element (10) generating electron-hole pairs in response to an irradiation with X-ray or gamma radiation (3),
- an anode electrode (20) arranged on a first surface (11) of the semiconductor element (10), said anode electrode (20) being segmented into anode segments (21) representing anode pixels, wherein anode gaps (22) are arranged between said anode segments (21),
- a cathode electrode (30) arranged on a second surface (12) of the semiconductor element (10) opposite the first surface (11), said cathode electrode (30) being segmented into first and second cathode segments (31, 32), which are arranged in a plane and in parallel to the second surface, wherein said first cathode segments (31) are substantially arranged opposite said anode segments (21) and said second cathode segments (32) are substantially arranged opposite said anode gaps (22), and
- a cathode terminal (41, 42) providing electrical connections to said first cathode segments (31) and said second cathode segments (32) for coupling different electrical potentials to said first and second cathode segments(31, 32).

2. The radiation detector as claimed in claim 1,
wherein said first cathode segments (31) are arranged as an array of first cathode segments.

3. The radiation detector as claimed in claim 1,
wherein said first cathode segments (31) have substantially the same form in directions parallel to the second surface (12) than said anode segments (21).

4. The radiation detector as claimed in claim 1,
wherein said first cathode segments (31) are separated from each other and are individually coupled to a first cathode terminal (41).

5. The radiation detector as claimed in claim 1,
wherein said first cathode segments (31a) are coupled together in groups, in particular per row or per column, by cathode connection electrodes (33a) arranged on said second surface (12) of said semiconductor element (10), said groups being individually coupled to a first cathode terminal (41).

6. The radiation detector as claimed in claim 1,
wherein said second cathode segments (32) are arranged as a grid of second cathode segments.

7. The radiation detector as claimed in claim 1,
wherein said second cathode segments (32a) are coupled together in a single or multiple groups being coupled to one or multiple second cathode terminals (42).

8. The radiation detector as claimed in claim 1,
wherein said cathode electrode (30b) is segmented into at least three cathode segments (31b, 32b, 33b), wherein said first cathode segments (31b) are substantially arranged opposite said anode segments (21) and the further cathode segments (32b, 33b) are nested around said first cathode segments (31b), and
wherein said cathode terminal provides electrical connections to different cathode segments (31b, 32b, 33b) for coupling different electrical potentials to said different cathode segments (31b, 32b, 33b).

9. The radiation detector as claimed in claim 1,
wherein said semiconductor element (10) is made from an elemental semiconductor material, in particular Si or Ge, a binary semiconductor material selected from the IV-group of the periodic system, in particular SiGe or SiC, a binary semiconductor material from the groups III and V of the periodic system, in particular InP, GaAs or GaN, a binary semiconductor material from the groups II and VI of the periodic system, in particular CdTe, HgTe, CdSe or ZnS, a binary semiconductor material from the groups IV and VI of the periodic system, in particular PbO or PbS, a ternary semiconductor material, in particular CdZnTe, HgCdTe, or AlGaAs, or a quaternary semiconductor material, in particular InGaAsP or InGaAlP.

10. The radiation detector as claimed in claim 1, further comprising:
- anode gap segments (23c) arranged within said anode gaps (22c) between adjacent anode segments (21c) and
- an anode terminal (51, 52) providing electrical connections to said anode gap segments (23c) for coupling an electrical potential to said anode gap segments (23c), in particular an electrical potential that is more negative than the electrical potential of said anode segments (21c).

11. A radiation detector comprising:
- a radiation sensitive semiconductor element generating electron-hole pairs in response to an irradiation with X-ray or gamma radiation,
- a cathode electrode arranged on a first surface of the semiconductor element, said cathode electrode being segmented into cathode segments representing cathode pixels, wherein cathode gaps are arranged between said cathode segments,
- an anode electrode arranged on a second surface of the semiconductor element opposite the first surface, said anode electrode being segmented into first and second anode segments, which are arranged in a plane and in parallel to the second surface, wherein said first anode segments are substantially arranged opposite said cathode segments and said second anode segments are substantially arranged opposite said cathode gaps, and
- an anode terminal providing electrical connections to said first anode segments and said second anode segments for coupling different electrical potentials to said first and second anode segments.

12. A radiation detection apparatus comprising:
- a radiation detector (2, 2a, 2b, 2c) as claimed in claim 1, and
- a voltage source (5) coupled to said cathode terminal (41, 42) for coupling different electrical potentials to said first and second cathode segments (31, 32).

13. The radiation detection apparatus as claimed in claim 12,
wherein said voltage source (5) is adapted for coupling an electrical potential to said second cathode segments (32) that provides a larger voltage difference to said anode electrode (20) than an electrical potential coupled to said first cathode segments (31).

14. The radiation detection apparatus as claimed in claim 12,
wherein said voltage source (5) is adapted for coupling electrical potentials to said first and second cathode segments (31, 32) having a voltage difference in the range between 10 V and 200 V.

15. A radiation detection apparatus comprising:
- a radiation detector as claimed in claim 11, and
- a voltage source coupled to said anode terminal for coupling different electrical potentials to said first and second anode segments.

## Patentansprüche

1. Strahlungsdetektor umfassend:
- ein strahlungsempfindliches Halbleiterelement (10), das in Reaktion auf eine Bestrahlung mit Röntgen- oder Gammastrahlung (3) Elektronen-Loch-Paare erzeugt,
- eine Anodenelektrode (20), die auf einer ersten Oberfläche (11) des Halbleiterelements (10) angeordnet ist, wobei die genannte Anodenelektrode (20) in Anodensegmente (21) segmentiert ist, welche Anodenpixel darstellen, wobei Anodenlücken (22) zwischen den genannten Anodensegmenten (21) angeordnet sind,
- eine Kathodenelektrode (30), die auf einer zweiten Oberfläche (12) des Halbleiterelements (10) gegenüber der ersten Oberfläche (11) angeordnet ist, wobei die genannte Kathodenelektrode (30) in erste und zweite Kathodensegmente (31, 32) segmentiert ist, die in einer Ebene und parallel zu der zweiten Oberfläche angeordnet sind, wobei die genannten ersten Kathodensegmenten (31) im Wesentlichen gegenüber den genannten Anodensegmenten (21) angeordnet sind und die genannten zweiten Kathodensegmente (32) im Wesentlichen gegenüber den genannten Anodenlücken (22) angeordnet sind, und
- einen Kathodenanschluss (41, 42), der elektrische Verbindungen zu den genannten ersten Kathodensegmenten (31) und den genannten zweiten Kathodensegmenten (32) bereitstellt, um verschiedene elektrische Potenziale mit den genannten ersten und zweiten Kathodensegmenten (31, 32) zu koppeln.

2. Strahlungsdetektor nach Anspruch 1,
wobei die genannten ersten Kathodensegmente (31) als ein Array aus ersten Kathodensegmenten angeordnet sind.

3. Strahlungsdetektor nach Anspruch 1,
wobei die genannten ersten Kathodensegmente (31) im Wesentlichen die gleiche Form in Richtungen parallel zu der zweiten Oberfläche (12) haben wie die genannten Anodensegmente (21).

4. Strahlungsdetektor nach Anspruch 1,
wobei die genannten ersten Kathodensegmente (31) voneinander getrennt sind und einzeln mit einem ersten Kathodenanschluss (41) gekoppelt sind.

5. Strahlungsdetektor nach Anspruch 1,
wobei die ersten Kathodensegmente (31a) durch Kathodenverbindungselektroden (33a), die auf der genannten zweiten Oberfläche (12) des genannten Halbleiterelements (10) angeordnet sind, in Gruppen zusammengekoppelt sind, insbesondere pro Reihe oder pro Spalte, wobei die genannten Gruppen einzeln mit einem ersten Kathodenanschluss (41) gekoppelt sind.

6. Strahlungsdetektor nach Anspruch 1,
wobei die genannten zweiten Kathodensegmente (32) als ein Gitter von zweiten Kathodensegmente angeordnet sind.

7. Strahlungsdetektor nach Anspruch 1,
wobei die genannten zweiten Kathodensegmente (32a) in einer einzelnen oder in mehreren Gruppen zusammengekoppelt sind, die mit einem oder mehreren zweiten Kathodenanschlüssen (42) gekoppelt sind.

8. Strahlungsdetektor nach Anspruch 1,
wobei die genannte Kathodenelektrode (30b) in mindestens drei Kathodensegmente (31b, 32b, 33b) segmentiert ist, wobei die genannten ersten Kathodensegmente (31b) im Wesentlichen gegenüber den genannten Anodensegmenten (21) angeordnet sind und die weiteren Kathodensegmente (32b, 33b) um die genannten ersten Kathodensegmente (31b) herum verschachtelt sind, und
wobei der genannte Kathodenanschluss elektrische Verbindungen zu verschiedenen Kathodensegmenten (31b, 32b, 33b) bereitstellt, um verschiedene elektrische Potenziale mit den genannten verschiedenen Kathodensegmenten (31b, 32b, 33b) zu koppeln.

9. Strahlungsdetektor nach Anspruch 1,
wobei das genannte Halbleiterelement (10) hergestellt ist aus einem Halbleitermaterial in Elementform, insbesondere Si oder Ge, einem binären Halbleitermaterial ausgewählt aus der Gruppe IV des Periodensystems, insbesondere SiGe oder SiC, einem binären Halbleitermaterial aus den Gruppen III und V des Periodensystems, insbesondere InP, GaAs oder GaN, einem binären Halbleitermaterial aus den Gruppen II und VI des Periodensystems, insbesondere CdTe, HgTe, CdSe oder ZnS, einem binären Halbleitermaterial aus den Gruppen IV und VI des Periodensystems, insbesondere PbO oder PbS, einem ternären Halbleitermaterial, insbesondere CdZnTe, HgCdTe oder AlGaAs, oder einem quaternären Halbleitermaterial, insbesondere InGaAsP oder InGaAlP.

10. Strahlungsdetektor nach Anspruch 1, ferner umfassend:
- Anodenlückensegmente (23c), die innerhalb der genannten Anodenlücken (22c) zwischen benachbarten Anodensegmenten (21c) angeordnet sind, und
- einen Anodenanschluss (51, 52), der elektrische Verbindungen zu den genannten Anodenlückensegmenten (23c) bereitstellt, um ein elektrisches Potenzial mit den genannten Anodenlückensegmente (23c) zu koppeln, insbesondere ein elektrisches Potenzial, das negativer ist als das elektrische Potenzial der genannten Anodensegmente (21c).

11. Strahlungsdetektor umfassend:
- ein strahlungsempfindliches Halbleiterelement, das in Reaktion auf eine Bestrahlung mit Röntgen- oder Gammastrahlung Elektronen-Loch-Paare erzeugt,
- eine Kathodenelektrode, die auf einer ersten Oberfläche des Halbleiterelements angeordnet ist, wobei die genannte Kathodenelektrode in Kathodensegmente segmentiert ist, welche Kathodenpixel darstellen, wobei Kathodenlücken zwischen den genannten Kathodensegmenten angeordnet sind,
- eine Anodenelektrode, die auf einer zweiten Oberfläche des Halbleiterelements gegenüber der ersten Oberfläche angeordnet ist, wobei die genannte Anodenelektrode in erste und zweite Anodensegmente segmentiert ist, die in einer Ebene und parallel zu der zweiten Oberfläche angeordnet sind, wobei die genannten ersten Anodensegmente im Wesentlichen gegenüber den genannten Kathodensegmenten angeordnet sind und die genannten zweiten Anodensegmente im Wesentlichen gegenüber den genannten Kathodenlücken angeordnet sind, und
- einen Anodenanschluss, der elektrische Verbindungen zu den genannten ersten Anodensegmenten und den genannten zweiten Anodensegmenten bereitstellt, um verschiedene elektrische Potenziale mit den genannten ersten und zweiten Anodensegmenten zu koppeln.

12. Strahlungsdetektionsgerät umfassend:
- einen Strahlungsdetektor (2, 2a, 2b, 2c) nach Anspruch 1, und
- eine Spannungsquelle (5), die mit dem genannten Kathodenanschluss (41, 42) gekoppelt ist, um verschiedene elektrische Potenziale mit den genannten ersten und zweiten Kathodensegmenten (31, 32) zu koppeln.

13. Strahlungsdetektionsgerät nach Anspruch 12,
wobei die genannte Spannungsquelle (5) dafür ausgelegt ist, ein elektrisches Potenzial mit den genannten zweiten Kathodensegmenten (32) zu koppeln, das eine größere Spannungsdifferenz zu der genannten Anodenelektrode (20) bereitstelle als ein elektrisches Potenzial, das mit den genannten ersten Kathodensegmenten (31) gekoppelt ist.

14. Strahlungsdetektionsgerät nach Anspruch 12,
wobei die genannte Spannungsquelle (5) dafür ausgelegt ist, elektrische Potenziale mit den genannten ersten und zweiten Kathodensegmenten (31, 32) zu koppeln, die eine Spannungsdifferenz im Bereich zwischen 10 V und 200 V aufweisen.

15. Strahlungsdetektionsgerät umfassend:
- einen Strahlungsdetektor nach Anspruch 11, und
- eine Spannungsquelle, die mit dem genannten Anodenanschluss gekoppelt ist, um verschiedene elektrische Potenziale mit den genannten ersten und zweiten Anodensegmenten zu koppeln.

## Revendications

1. Détecteur de rayonnement comprenant :
- un élément semi-conducteur sensible à un rayonnement (10) générant des paires électron-trou en réponse à une irradiation par un rayonnement gamma ou de rayons X (3),
- une électrode anodique (20) disposée sur une première surface (11) de l'élément semi-conducteur (10), ladite électrode anodique (20) étant segmentée en segments anodiques (21) représentant des pixels anodiques, des espaces anodiques (22) étant disposés entre lesdits segments anodiques (21),
- une électrode cathodique (30) disposée sur une seconde surface (12) de l'élément semi-conducteur (10) opposée à la première surface (11), ladite électrode cathodique (30) étant segmentée en des premiers et seconds segments cathodiques (31, 32), qui sont disposés dans un plan et parallèlement à la seconde surface, lesdits premiers segments cathodiques (31) sont sensiblement disposés en vis-à-vis desdits segments anodiques (21) et lesdits seconds segments cathodiques (32) sont sensiblement disposés en vis-à-vis desdits espaces anodiques (22), et
- une borne cathodique (41, 42) fournissant des connexions électriques auxdits premiers segments cathodiques (31) et auxdits seconds segments cathodiques (32) pour coupler différents potentiels électriques auxdits premiers et seconds segments cathodiques (31, 32).

2. Détecteur de rayonnement selon la revendication 1,
dans lequel lesdits premiers segments cathodiques (31) sont agencés sous forme d'un réseau de premiers segments cathodiques.

3. Détecteur de rayonnement selon la revendication 1,
dans lequel lesdits premiers segments cathodiques (31) ont sensiblement la même forme dans des directions parallèles à la seconde surface (12) que lesdits segments anodiques (21).

4. Détecteur de rayonnement selon la revendication 1,
dans lequel lesdits premiers segments cathodiques (31) sont séparés les uns des autres et sont couplés individuellement à une première borne cathodique (41).

5. Détecteur de rayonnement selon la revendication 1,
dans lequel lesdits premiers segments cathodiques (31a) sont couplés ensemble en groupes, en particulier par rangée ou par colonne, par des électrodes de connexion cathodique (33a) agencées sur ladite seconde surface (12) dudit élément semi-conducteur (10), lesdits groupes étant couplés individuellement à une première borne cathodique (41).

6. Détecteur de rayonnement selon la revendication 1,
dans lequel lesdits seconds segments cathodiques (32) sont agencés sous forme d'une grille de seconds segments cathodiques.

7. Détecteur de rayonnement selon la revendication 1,
dans lequel lesdits seconds segments cathodiques (32a) sont couplés ensemble en un groupe unique ou de multiples groupes qui sont couplés à une ou de multiples secondes bornes cathodiques (42).

8. Détecteur de rayonnement selon la revendication 1,
dans lequel ladite électrode cathodique (30b) est segmentée en au moins trois segments cathodiques (31b, 32b, 33b), dans lequel lesdits premiers segments cathodiques (31b) sont sensiblement disposés en vis-à-vis desdits segments anodiques (21) et les autres segments cathodiques (32b, 33b) sont imbriqués autour desdits premiers segments cathodiques (31b), et
dans lequel ladite borne cathodique fournit des connexions électriques à différents segments cathodiques (31b, 32b, 33b) pour coupler différents potentiels électriques auxdits différents segments cathodiques (31b, 32b, 33b).

9. Détecteur de rayonnement selon la revendication 1,
dans lequel ledit élément semi-conducteur (10) est constitué d'un matériau semi-conducteur élémentaire, en particulier Si ou Ge, d'un matériau semi-conducteur binaire choisi parmi le groupe IV du système périodique, en particulier SiGe ou SiC, d'un matériau semi-conducteur binaire des groupes III et V du système périodique, en particulier InP, GaAs ou GaN, d'un matériau semi-conducteur binaire des groupes II et VI du système périodique, en particulier CdTe, HgTe, CdSe ou ZnS, d'un matériau semi-conducteur binaire des groupes IV et VI du système périodique, en particulier PbO ou PbS, d'un matériau semi-conducteur ternaire, en particulier CdZnTe, HgCdTe, ou AlGaAs, ou d'un matériau semi-conducteur quaternaire, en particulier InGaAsP ou InGaAlP.

10. Détecteur de rayonnement selon la revendication 1, comprenant en outre :
- des segments d'espace anodique (23c) disposés à l'intérieur desdits espaces anodiques (22c) entre des segments anodiques adjacents (21c) et
- une borne anodique (51, 52) fournissant des connexions électriques auxdits segments d'espace anodique (23c) pour coupler un potentiel électrique auxdits segments d'espace anodique (23c), en particulier un potentiel électrique qui est plus négatif que le potentiel électrique desdits segments anodiques (21c).

11. Détecteur de rayonnement comprenant :
- un élément semi-conducteur sensible à un rayonnement générant des paires électron-trou en réponse à une irradiation par un rayonnement gamma ou de rayons X,
- une électrode cathodique disposée sur une première surface de l'élément semi-conducteur, ladite électrode cathodique étant segmentée en segments cathodiques représentant des pixels cathodiques, des espaces cathodiques étant disposés entre lesdits segments cathodiques,
- une électrode anodique disposée sur une seconde surface de l'élément semi-conducteur opposée à la première surface, ladite électrode anodique étant segmentée en des premiers et seconds segments anodiques, qui sont disposés dans un plan et parallèlement à la seconde surface, lesdits premiers segments anodiques étant sensiblement agencés en vis-à-vis desdits segments cathodiques et desdits seconds segments anodiques étant sensiblement agencés en vis-à-vis desdits espaces cathodiques, et
- une borne anodique fournissant des connexions électriques auxdits premiers segments anodiques et auxdits seconds segments anodiques pour coupler différents potentiels électriques auxdits premiers et seconds segments anodiques.

12. Appareil de détection de rayonnement comprenant :
- un détecteur de rayonnement (2, 2a, 2b, 2c) selon la revendication 1, et
- une source de tension (5) couplée à ladite borne cathodique (41, 42) pour coupler différents potentiels électriques auxdits premiers et seconds segments cathodiques (31, 32).

13. Appareil de détection de rayonnement selon la revendication 12,
dans lequel ladite source de tension (5) est adaptée pour coupler un potentiel électrique auxdits seconds segments cathodiques (32) qui fournit une différence de tension plus grande à ladite électrode anodique (20) qu'un potentiel électrique couplé auxdits premiers segments cathodiques (31).

14. Appareil de détection de rayonnement selon la revendication 12,
dans lequel ladite source de tension (5) est adaptée pour coupler des potentiels électriques auxdits premier et second segments cathodiques (31, 32) ayant une différence de tension dans la plage comprise entre 10 V et 200 V.

15. Appareil de détection de rayonnement comprenant :
- un détecteur de rayonnement selon la revendication 11, et
- une source de tension couplée à ladite borne anodique pour coupler différents potentiels électriques auxdits premiers et seconds segments anodiques.
